# EUROPEAN PATENT SPECIFICATION

(11) **EP 4 329 464 B1**
(45) Date of publication and mention of the grant of the patent: **23.07.2025**
(21) Application number: 23764817.5
(22) Date of filing: 05.05.2023
(51) Int. Cl.: H10N 60/01, G06N 10/40

(54) **PREPARATION METHOD AND SYSTEM FOR JOSEPHSON JUNCTION**
VERFAHREN UND SYSTEM ZUR HERSTELLUNG EINES JOSEPHSON-KONTAKTS
PROCÉDÉ ET SYSTÈME DE PRÉPARATION POUR JONCTION JOSEPHSON

(30) Priority: 23.06.2022 CN 202210726039
(43) Date of publication of application: 28.02.2024
(73) Proprietor: Tencent Technology (Shenzhen) Company Limited, Shenzhen, Guangdong 518057 (CN)
(72) Inventor: LI, Dengfeng, Shenzhen, Guangdong 518057 (CN); ZHANG, Wenlong, Shenzhen, Guangdong 518057 (CN); DAI, Maochun, Shenzhen, Guangdong 518057 (CN); BU, Kunliang, Shenzhen, Guangdong 518057 (CN)
(74) Representative: Novagraaf International SA
(86) International application number: PCT/CN2023/092199
(87) International publication number: WO 2023/246326

(56) References cited:
- WO-A1-2019/032115
- WO-A1-2019/032115
- CN-A- 111 403 590
- CN-A- 112 885 952
- CN-A- 113 380 942
- CN-A- 113 903 854
- CN-A- 113 903 854
- CN-A- 114 256 407
- CN-A- 114 256 407
- US-A1- 2005 123 674
- US-A1- 2020 388 745
- US-A1- 2021 399 199

## Description

### RELATED APPLICATION

This invention claims priority to Chinese Patent Application NO. 202210726039.6 entitled "METHOD AND SYSTEM FOR PREPARING JOSEPHSON JUNCTION" filed on June 23, 2022.

### FIELD OF THE TECHNOLOGY

The present invention relates to the technical field of micro-nano processing, and particularly to a method and system for preparing a Josephson junction.

### BACKGROUND OF THE DISCLOSURE

Currently, a Josephson junction is a commonly used qubit structure that may be prepared by a pre-designed photoresist structure.

In the related art, a Doran bridge photoresist structure graphic containing an undercut is made on a double-layer electron beam photoresist on a surface of a substrate by an electron beam exposure method. Then the Josephson junction is prepared by a double-dip evaporation method in which a superconducting metal film is firstly evaporated obliquely and then an insulating layer is formed by oxidation, and finally, the superconducting metal film is vertically evaporated.

Then, in the above-described solution for preparing the Josephson junction, an extra Josephson junction (also referred to as a parasitic junction) is introduced into the prepared qubit component, thereby affecting the coherence of the qubit component.

WO 2019/032115 A1 concerns methods of fabricating quantum circuit assemblies that include Josephson Junctions connected below the plane of supporting circuitry.

CN 114 256 407 A concerns a production method of imbalance power without energy source.

CN 113 903 854 A concerns a superconducting chip to be applied to the field of quantum computing.

US 2005/123674 A1 concerns a method of building a superconductor device on a substrate, comprising depositing an imprint layer on at least a portion of the substrate. The imprint layer is imprinted to provide an imprinted portion of the imprint layer and a non-imprinted portion of the imprint layer. A superconductor layer is deposited on at least a portion of the imprinted portion of the imprint layer.

### SUMMARY

The present invention is defined by the appended claims. Embodiments of this invention, hereinafter designated as application, provide a method and system for preparing a Josephson junction, which may avoid introducing a parasitic junction and improve coherence time of a qubit component, and the technical solution is as follows.

In one aspect, a method for preparing a Josephson junction is provided. The method is performed by a production line device and includes:
preparing a circuit structure on a substrate by nano-imprinting; the circuit structure including a first lead, a second lead, and a peripheral circuit connected to the first lead and the second lead; and the first lead, the second lead, and the peripheral circuit being of an integral structure;
preparing a photoresist-based undercut structure on the substrate; the undercut structure being a strip-shaped structure, and the undercut structure including a first region, a second region, and a third region connected between the first region and the second region; the first region and the second region having upper photoresist layers and lower layers of hollow-out; the third region being an opening region of the undercut structure; the first region covering an end of the first lead; the second region covering a portion of the second lead; and the third region being located between the first region and the second region;
preparing an oxide layer on a surface of the second lead which is not covered by the photoresist;
evaporating a first superconducting layer obliquely in a direction from the first region to the second region to obtain the Josephson junction; and the first superconducting layer covering a region on the second lead which is not covered by the photoresist and a portion of the substrate between the second lead and the first lead; and
evaporating a second superconducting layer obliquely in a direction from the second region to the first region; and the second superconducting layer covering a region on the first lead which is not covered by the photoresist, the portion of the substrate between the second lead and the first lead, and a portion of the first superconducting layer.

In yet another aspect, a system for preparing a Josephson junction is provided, and the system includes: a nano-imprinting subsystem, a photolithography subsystem, an oxidation subsystem, and an evaporation subsystem;
the nano-imprinting subsystem, configured to prepare a circuit structure on a substrate by nano-imprinting; the circuit structure including a first lead, a second lead, and a peripheral circuit connected to the first lead and the second lead; and the first lead, the second lead, and the peripheral circuit being of an integral structure;
the photolithography subsystem, configured to prepare a photoresist-based undercut structure on the substrate; the undercut structure being a strip-shaped structure, and the undercut structure including a first region, a second region, and a third region connected between the first region and the second region; the first region and the second region having upper photoresist layers and lower layers of hollow-out; the third region being an opening region of the undercut structure; the first region covering an end of the first lead; the second region covering a portion of the second lead; and the third region being located between the first region and the second region;
the oxidation subsystem, configured to prepare an oxide layer on a surface of the second lead which is not covered by the photoresist;
the evaporation subsystem, configured to evaporate a first superconducting layer obliquely in a direction from the first region to the second region to obtain the Josephson junction; and the first superconducting layer covering a region on the second lead which is not covered by the photoresist and a portion of the substrate between the second lead and the first lead; and
the evaporation subsystem, further configured to evaporate a second superconducting layer obliquely in a direction from the second region to the first region; and the second superconducting layer covering a region on the first lead which is not covered by the photoresist, the portion of the substrate between the second lead and the first lead, and a portion of the first superconducting layer.

In one possible implementation, the undercut structure further includes a fourth region; the fourth region is an opening region of the undercut structure; and the second region is located between the third region and the fourth region.

In one possible implementation, a length of the second region is greater than that of the first region, and the portion of the second lead covered by the second region is located on a side of the second region close to the third region.

In one possible implementation, the oxidation subsystem is configured to place the substrate into an oxidation chamber in a pure oxygen environment for oxidation;
the system for preparing a Josephson junction further includes: an etching subsystem, configured to perform ion etching obliquely in the direction from the second region to the first region to remove an oxide layer on a surface of the first lead which is not covered by the photoresist.

In one possible implementation, the performing ion etching obliquely in the direction from the second region to the first region has a duration of 2 minutes at an etching power of 200 watts.

In one possible implementation, a pressure in the oxidation chamber is 4 Torr; and an oxidation duration of the substrate in the oxidation chamber is 1,000 to 2,000 seconds.

In one possible implementation, the etching subsystem is further configured to performing the ion etching on surfaces of the first lead and the second lead which are not covered by the photoresist.

In one possible implementation, the etch subsystem is configured to rotate the substrate while keeping an inclination angle of the ion etching constant.

In one possible implementation, the first superconducting layer has a coating growth rate of 1 nanometer (nm) per second; and a thickness of the first superconducting layer is 100 nm.

In one possible implementation, an extension line of the first lead intersects the second lead.

In one possible implementation, the first lead is perpendicular to the second lead, and the first lead is parallel to the undercut structure.

In one possible implementation, the nano-imprinting subsystem is configured to,
prepare a superconducting film layer on the substrate;
spin coat nano-imprinting adhesive on the superconducting film layer;
imprint a structure pattern of the circuit structure on the nano-imprinting adhesive through a nano-imprinting mask plate;
etch on the superconducting film layer based on the structure pattern; and
wash the nano-imprinting adhesive on the substrate to obtain the circuit structure located on the substrate.

In one possible implementation, a thickness of the superconducting film layer is 100 nm.

In one possible implementation, the nano-imprinting subsystem is configured to etch on the superconducting film layer based on the structure pattern by dry etching.

In one possible implementation, the nano-imprinting subsystem is further configured to remove nano-imprinting adhesive remaining in an imprint groove of the nano-imprinting adhesive.

The technical solutions provided in embodiments of this application have at least the following beneficial effects.

In the preparation of a quantum computing device, firstly, the peripheral circuit of the Josephson junction and leads connecting the Josephson junction with the peripheral circuit are prepared by nano-imprinting, and the leads and the peripheral circuit are of an integral structure so that the subsequently prepared Josephson junction does not need to additionally prepare a Josephson junction patch/Josephson junction bandage to connect with the peripheral circuit. Then, the first superconducting layer and the second superconducting layer are prepared by evaporation of superconducting materials in two inclined directions through the undercut structure. The first superconducting layer forms the Josephson junction at the intersection with the second lead, and the second superconducting layer connects the first superconducting layer and the end of the first lead, thereby performing a superconducting connection between the end of the first lead and the Josephson junction. When the Josephson junction in the quantum computing device is prepared by the above-mentioned solution, the introduction of the parasitic junction may be avoided to improve the coherence time of the qubit component, thereby improving the performance of the quantum computing device.

### BRIEF DESCRIPTION OF THE DRAWINGS

FIG. 1 is a preparation effect diagram of a Josephson junction according to this application.
FIG. 2 is a method flowchart of a method for preparing a Josephson junction according to an exemplary embodiment of this application.
FIG. 3 is a schematic diagram of an undercut structure according to an embodiment shown in FIG. 2.
FIG. 4 is a preparation flowchart of a Josephson junction according to an exemplary embodiment of this application.
FIG. 5 is a method flowchart of a method for preparing a Josephson junction according to an exemplary embodiment of this application.
FIG. 6 is a schematic diagram of a circuit structure and undercut structure according to an embodiment shown in FIG. 5.
FIG. 7 is a schematic diagram of another circuit structure and undercut structure according to an embodiment shown in FIG. 5.
FIG. 8 is a schematic diagram of a result after oxidation according to an embodiment shown in FIG. 5.
FIG. 9 is a diagram of an effect after evaporating the aluminum according to an embodiment shown in FIG. 5.
Fig. 10 is a schematic diagram of oxide layer removal according to an embodiment shown in FIG. 5.
FIG. 11 is a schematic diagram of a Josephson junction region according to an embodiment shown in FIG. 5.
FIG. 12 is a flowchart of the preparation of a quantum computing device according to an exemplary embodiment of this application.
FIG. 13 is a schematic diagram of a product application scene according to an embodiment of this application.
FIG. 14 is a schematic diagram of a system for preparing a Josephson junction according to an exemplary embodiment of this application.

### DESCRIPTION OF EMBODIMENTS

First, definitions of some terms involved in this application are introduced.

Qubit: in quantum informatics, it is a unit of measurement of quantum information. Unlike a classical bit that can only be in one of the states 0 or 1, the qubit may be in both of the states 0 and 1, i.e., quantum superposition states of 0 and 1.

Josephson Junction: a sandwich structure formed by stacking a superconducting layer, an insulating layer, and a superconducting layer, also referred to as a superconducting tunnel junction. The Josephson junction is generally a structure formed by sandwiching two superconductors with a very thin barrier layer (thickness ≤ a coherence length of a cooper electron pair), such as a superconductor (S)-semiconductor or insulator (I)-superconductor (S) structure, referred to as the SIS structure. In the Josephson junction, a superconducting electron may tunnel from a superconducting layer on one side through a semiconductor or insulator film to a superconducting layer on the other side.

Parasitic junction: other Josephson junctions brought during preparing the Josephson junction.

Shadow evaporation coating: in the evaporation coating, the evaporation material is made to be incident on the surface of the substrate (also referred to as an underlayment) at a certain angle, and at the same time, by defining a photoresist graphic in an incident path, a shield of a certain shape is provided so that some places on the surface of the substrate are selectively evaporated with the coating and other places are not evaporated with the coating.

Josephson junction patch: a portion of a superconducting quantum chip connecting the Josephson junction and an external circuit.

Josephson junction bandage: a portion of the superconducting quantum chip connecting the Josephson junction patch and the external circuit.

Ion milling: the surface of the material is bombarded with an ion beam directed at a direction to remove an oxide layer on the surface of the material.

Oblique evaporation: the evaporated material evaporates a film in a direction not parallel to a substrate normal.

Straight evaporation: the evaporated material evaporates the film in a direction parallel to the substrate normal.

Liftoff: a process in which the photoresist dissolves in a degumming solution and a metal layer on the photoresist is carried away from the substrate at the same time.

Coherence time: an ability of the qubit to maintain the association of different quantum states.

Undercut structure: a graphic structure formed by developing the photoresist with an upper opening size smaller than a lower opening size.

Insitu: a multi-step process is performed in a single vacuum chamber or in multiple interconnected vacuum chambers, during which a sample/product is not moved to the atmosphere.

A quantum computer haw received much attention because of its significantly better speed in dealing with certain specific problems than a classical computer. One possible approach to the quantum computer today is a superconducting quantum computer. The superconducting quantum computer relies on the superconducting quantum chip to achieve logic gate operations. The superconducting quantum chip may be viewed simply as consisting of the external circuit and the Josephson junction. The Josephson junction is the core element of the superconducting quantum chip.

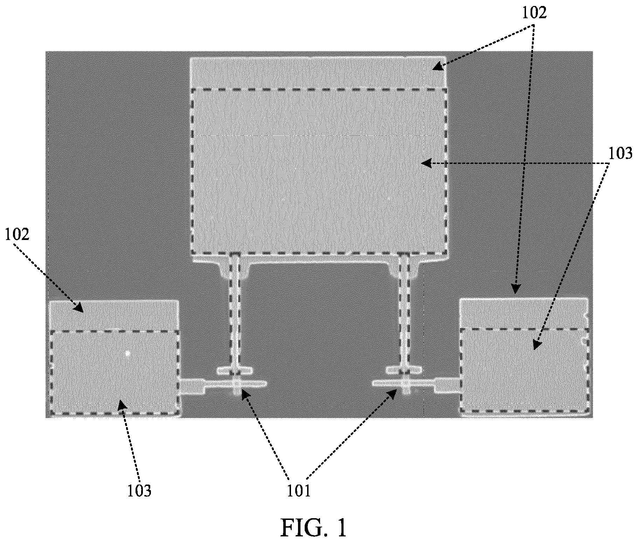

A method for preparing a Josephson junction is the shadow evaporation method, which forms the Josephson junction by performing ion milling, oblique incidence evaporation, oxidation, and normal incidence evaporation in the insitu. Referring to FIG. 1, it shows a preparation effect diagram of a Josephson junction according to this application. FIG. 1 shows two Josephson junctions 101 in parallel, which are connected to the external circuit through Josephson junction patches 102. As shown in FIG. 1, after performing ion milling, oblique incidence evaporation, oxidation, and normal incidence evaporation in the insitu, a parasitic junction 103 is formed in the qubit component, as shown in the dashed box portion of FIG. 1.

As shown in FIG. 1, when the Josephson junction is prepared according to the above-mentioned solution, a large area parasitic junction is introduced into the qubit component containing the Josephson junction, thereby affecting the coherence time of the qubit component, and thus affecting the performance of the quantum computing device.

To improve the performance of the qubit component whose structure is the Josephson junction, subsequent embodiments of this application provide a new solution for preparing the Josephson junction.

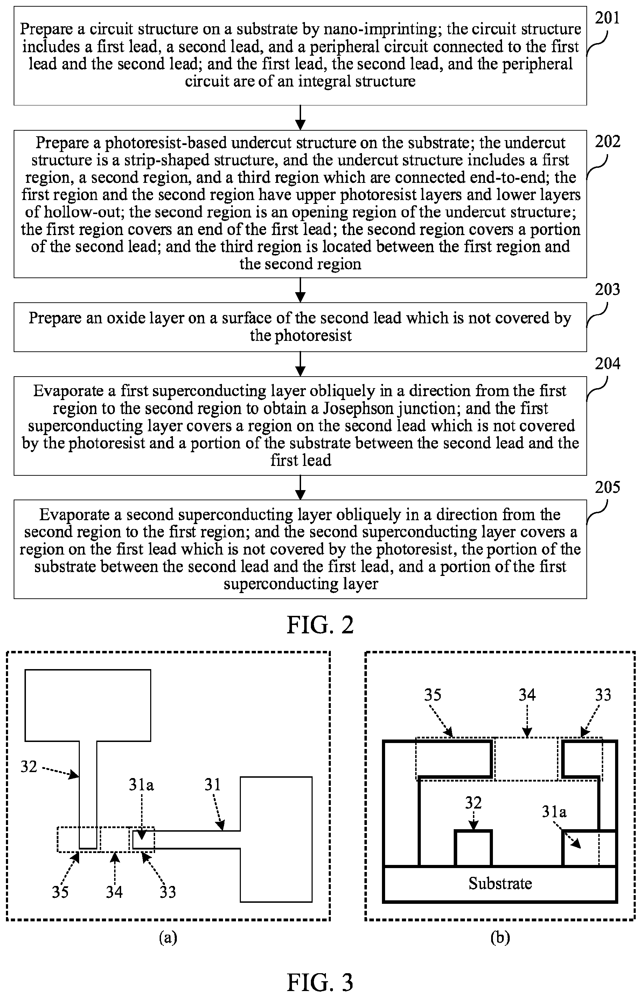

Referring to FIG. 2, it shows a method flowchart of a method for preparing a Josephson junction according to an exemplary embodiment of this application. The method may be performed by a production line device, as shown in FIG. 2, the method may include the following steps.

Step 201. Prepare a circuit structure on a substrate by nano-imprinting; the circuit structure includes a first lead, a second lead, and a peripheral circuit connected to the first lead and the second lead; and the first lead, the second lead, and the peripheral circuit are of an integral structure.

In one possible implementation, an extension line of the first lead intersects the second lead.

Nano-imprinting technology refers to a technology of transferring a micro-nano structure on a template to the material to be processed through the assistance of the photoresist.

The nano-imprinting technology may be divided into three steps.

The first step is to process the template. Typically, electron beam etching or the like is used to process a desired structure on silicon or other substrates as the template. Since the diffraction limit of electrons is much smaller than that of photons, much higher resolution than photolithography may be achieved.

The second step is to transfer a pattern. The photoresist is coated on the surface of the material to be processed, then the template is pressed on the surface thereof, and the pattern is transferred to the photoresist by pressurization.

The third step is to process the substrate. The photoresist is solidified by ultraviolet light, and after removing the template, the surface of the material to be processed is exposed, and then processing is performed using an etching method. After completing the processing, all the photoresist is removed, and finally, a material processed with high precision is obtained.

Step 202. Prepare a photoresist-based undercut structure on the substrate; the undercut structure is a strip-shaped structure, and the undercut structure includes a first region, a second region, and a third region connected between the first region and the second region; the first region and the second region have upper photoresist layers and lower layers of hollow-out; the second region is an opening region of the undercut structure; the first region covers an end of the first lead; the second region covers a portion of the second lead; and the third region is located between the first region and the second region.

The above-mentioned opening region refers to a region without the photoresist.

The above-mentioned first region covers the end of the first lead, which means that the first region is located above the end of the first lead in a direction perpendicular to the substrate. Accordingly, the second region covers the portion of the second lead, which means that the second region is located above the portion of the second lead in the direction perpendicular to the substrate.

In embodiments of this application, the photoresist-based undercut structure is strip-shaped and covers the first lead and the second lead at the same time. The photoresist is present above the portion of the first lead and the second lead covered by the undercut structure, and the opening region is present in the portion of the undercut structure between the first lead and the second lead.

For example, referring to FIG. 3, it shows a schematic diagram of an undercut structure according to an embodiment of this application. Portion (a) in FIG. 3 is a top view of the substrate after the undercut structure is prepared, and portion (b) in FIG. 3 is a cross-sectional view of the substrate along an extension direction of the undercut structure after the undercut structure is prepared. As shown in FIG. 3, the first lead 31 and the second lead 32 do not intersect, but the extension line of the first lead 31 intersects the second lead 32. The strip-shaped undercut structure extends from an end 31a of the first lead 31 all the way through the second lead 32, and contains a first region 33 (lower layer of hollow-out), a third region 34 (open a hole), and a second region 35 (lower layer of hollow-out). The first region 33 covers the end 31a of the first lead 31, and the second region 35 covers a portion of the second lead 32.

Step 203. Prepare an oxide layer on a surface of the second lead which is not covered by the photoresist (i.e. free from the photoresist).

In embodiments of this application, the above-mentioned oxide layer prepared on the surface of the second lead which is not covered by the photoresist will subsequently act as the insulating layer in the Josephson junction.

Step 204. Evaporate a first superconducting layer obliquely in a direction from the first region to the second region to obtain the Josephson junction; and the first superconducting layer covers a region on the second lead which is not covered by the photoresist (i.e. free from the photoresist) and a portion of the substrate between the second lead and the first lead.

In embodiments of this application, since there is an opening between the first region and the second region in the above-mentioned undercut structure, when the superconducting material is evaporated obliquely in the direction from the first region to the second region, the superconducting material will be evaporated obliquely to the surface of the second lead which is not covered by the photoresist through the opening to form the first superconducting layer. The first superconducting layer covers the portion of the substrate in addition to the surface of the second lead which is not covered by the photoresist. Since the surface of the second lead which is not covered by the photoresist and the oxide layer is prepared in advance, the first superconducting layer, the oxide layer, and the portion of the second lead which is not covered by the photoresist form the Josephson junction of "superconducting layer-insulating layer-superconducting layer".

Step 205. Evaporate a second superconducting layer obliquely in a direction from the second region to the first region; and the second superconducting layer covers a region on the first lead which is not covered by the photoresist, the portion of the substrate between the second lead and the first lead, and a portion of the first superconducting layer.

In one possible implementation, the above-mentioned implementation of step 204 to step 205 may be performed in an insitu environment.

Since the evaporation direction in step 204 is a direction inclined from the first region to the second region and since an upper portion of the first lead is the first region of the undercut structure, and there is shielding by the photoresist, the end of the first lead will not be evaporated with the superconducting material, that is to say, the first lead is not connected to the Josephson junction prepared in step 204. At this time, the second superconducting layer covering the end of the first lead may be obtained by evaporating obliquely in the direction from the second region to the first region, and at the same time, the second superconducting layer extends from the end of the first lead to the first superconducting layer; the Josephson junction is connected to the first lead to connect the Josephson junction to the peripheral circuit, constituting one superconducting qubit in the quantum computing device.

In summary, in the solution shown in embodiments of this application, in the preparation of the quantum computing device, firstly, the peripheral circuit of the Josephson junction and leads connecting the Josephson junction with the peripheral circuit are prepared by nano-imprinting, and the leads and the peripheral circuit are of an integral structure so that the subsequently prepared Josephson junction does not need to additionally prepare a Josephson junction patch/Josephson junction bandage to connect with the peripheral circuit. Then, the first superconducting layer and the second superconducting layer are prepared by evaporation of superconducting materials in two inclined directions through the undercut structure. The first superconducting layer forms the Josephson junction at the intersection with the second lead, and the second superconducting layer connects the first superconducting layer and the end of the first lead, thereby performing a superconducting connection between the end of the first lead and the Josephson junction. When the Josephson junction in the quantum computing device is prepared by the above-mentioned solution, the introduction of the parasitic junction may be avoided to improve the coherence time of the qubit component, thereby improving the performance of the quantum computing device.

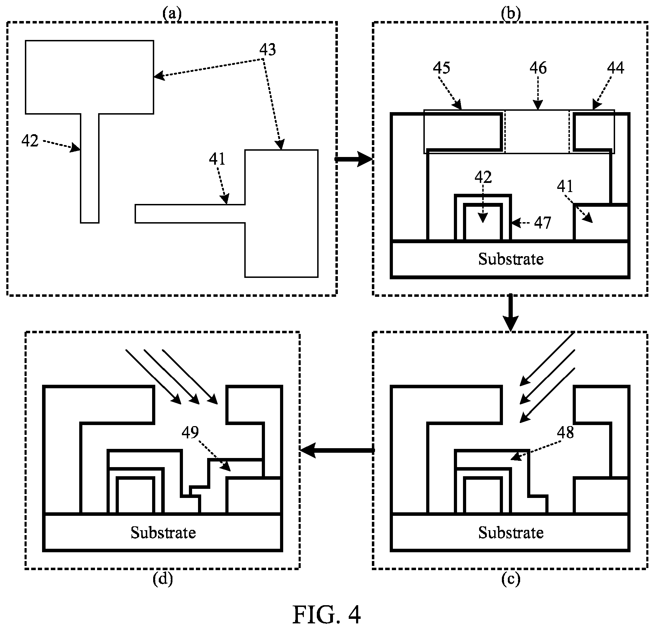

Based on the solution shown in FIG. 2, referring to FIG. 4, it shows a preparation schematic diagram of a Josephson junction according to an exemplary embodiment of this application. As shown in FIG. 4, a preparation flow of the Josephson junction may be as follows.

S1. Prepare the circuit structure on the substrate by nano-imprinting.

As shown in portion (a) of FIG. 4, the circuit structure includes a first lead 41, a second lead 42, and a peripheral circuit 43 connected to the first lead 41 and the second lead 42,

The first lead 41 and the second lead 42 do not intersect, and an extension line of the first lead 41 intersects the second lead 42 (that is to say, the first lead 41 and the second lead 42 are not parallel). The above-mentioned first lead 41, second lead 42, and peripheral circuit are of an integral structure prepared by nano-imprinting, and there is no Josephson junction patch or Josephson junction bandage.

S2. Prepare the photoresist-based undercut structure on the substrate.

As shown in portion (b) of FIG. 4, the undercut structure is a strip-shaped structure, and the undercut structure includes a first region 44, a second region 45, and a third region 46 connected between the first region 44 and the second region 45. The first region 44 covers an end of the first lead 41. The second region 45 covers a portion of the second lead 42. The third region 46 is located between the first region 44 and the second region 45.

S3. Prepare the oxide layer on the surface of the second lead which is not covered by the photoresist.

As shown in portion (b) of FIG. 4, an oxide layer 47 may be generated by oxidation after the superconducting material constituting the second lead contacts with pure oxygen, and since only the portion of the second lead covered by the second region may contact with the pure oxygen environment, the above-mentioned oxide layer 47 may also be limited to the surface of the second lead which is not covered by the photoresist.

S4. Evaporate the first superconducting layer obliquely in the direction from the first region to the second region.

As shown in portion (c) of FIG. 4, due to the undercut structure constituting the first region 44, the second region 45, and the third region 46, when the superconducting material is evaporated obliquely in the direction from the first region to the second region, the superconducting material will be obliquely incident at the second lead through the opening at the third region 46, but will not be incident at the first lead, thereby forming a first superconducting layer 48 on the second lead and a portion of the substrate between the second lead and the first lead. The second lead 42, the oxide layer 47, and the first superconducting layer 48 constitute the Josephson junction at the second lead 42.

S5. Evaporate the second superconducting layer obliquely in the direction from the second region to the first region.

As shown in portion (d) of FIG. 4, a second superconducting layer 49 covers a region on the first lead 41 which is not covered by the photoresist, a portion of the substrate between the second lead 42 and the first lead 41, and a portion of the first superconducting layer 48. The second superconducting layer 49 superconductively connects the first superconducting layer 48 to the first lead 41 such that the second lead 42, the oxide layer 47, and the first superconducting layer 48 constitute the Josephson junction at the second lead 42 into the peripheral circuit.

In the above solutions shown in FIG. 2 and FIG. 4, in the process of preparing the oxide layer on the surface of the second lead which is not covered by the photoresist, the oxide layer may be first prepared on the surfaces of the first lead and the second lead which are not covered by the photoresist, and then the oxide layer on the surface of the first lead which is not covered by the photoresist may be removed.

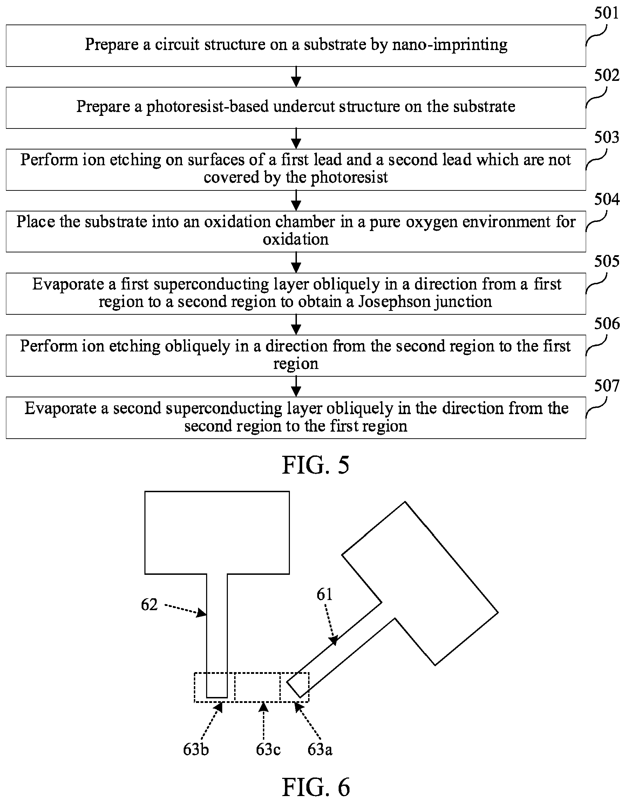

Referring to FIG. 5, it shows a method flowchart of a method for preparing a Josephson junction according to an exemplary embodiment of this application. As shown in FIG. 5, the method may include the following steps:

Step 501. Prepare the circuit structure on the substrate by nano-imprinting.

The above-mentioned circuit structure includes the first lead, the second lead, and the peripheral circuit connected to the first lead and the second lead. The first lead, the second lead, and the peripheral circuit are of an integral structure.

In one possible implementation, the extension line of the first lead intersects the second lead.

In one possible implementation, the above-mentioned preparing the circuit structure on the substrate by nano-imprinting includes:
preparing a superconducting film layer on the substrate;
spin coating nano-imprinting adhesive on the superconducting film layer;
imprinting a structure pattern of the circuit structure on the nano-imprinting adhesive through a nano-imprinting mask plate;
etching on the superconducting film layer based on the structure pattern; and
washing the nano-imprinting adhesive on the substrate to obtain the circuit structure located on the substrate.

In embodiments of this application, a thickness of the above-mentioned superconducting film layer may be controlled so that the superconducting film layer meets the circuit requirements of the quantum computing device, for example, the thickness of the above-mentioned superconducting film layer may be set between 80 nanometers (nm) and 120 nm.

For example, in one possible implementation of embodiments of this application, the thickness of the above-mentioned superconducting film layer may be 100 nm.

For example, in embodiments of this application, the superconducting material (such as aluminum) may be evaporated on the substrate through an evaporator, and the thickness of the superconducting film layer may be controlled to be about 100 nm by controlling factors such as an evaporation duration and a growth rate of the superconducting film layer.

In one possible implementation, the above-mentioned etching on the superconducting film layer based on the structure pattern may include:
etching on the superconducting film layer based on the structure pattern by dry etching.

Alternatively, in another possible implementation, etching may also be performed on the superconducting film layer based on the structure pattern by wet etching.

In one possible implementation, the nano-imprinting adhesive remaining in an imprint groove of the nano-imprinting adhesive may also be removed before etching on the superconducting film layer based on the structure pattern.

Firstly, high-quality aluminum films of 100 nm thickness are grown on sapphire or silicon substrates using electron beam evaporation or molecular beam epitaxy (MBE) device. Then, the nano-imprinting adhesive is spin coated on the aluminum film. Later, the circuit structure of the quantum chip is imprinted on the adhesive using a nano-imprinting device and a nano-imprinting mask plate, including a read line, a resonant cavity, a capacitor, etc., and the underlying aluminum of the Josephson junction. And then the remaining photoresist in the nano-imprinting adhesive groove is removed using a plasma degumming device. Finally, the pattern is etched on the aluminum film using dry etching or wet etching. When using dry etching, a structure size may be controlled more precisely, and the etched aluminum film structure has a better property. After etching the aluminum film structure, the nano-imprinting adhesive may be washed away, and a result of portion (a) in FIG. 4 is finally obtained. The peripheral circuit 43 represents a large circuit structure, and a line width is generally a few microns to a few tens of microns, and this portion may be connected to circuits other than the chip through leads. The first lead 41 and the second lead 42 may represent the underlying aluminum of the Josephson junction, and a line width may be below 200 nm.

The above-mentioned peripheral circuit may include a micro-scale circuit having a relatively large size such as the read line, the resonant cavity, and the capacitor.

Step 502. Prepare the photoresist-based undercut structure on the substrate.

The undercut structure is a strip-shaped structure, and the undercut structure includes the first region, the second region, and the third region connected between the first region and the second region. The first region and the second region have upper photoresist layers and lower layers of hollow-out. The second region is the opening region of the undercut structure. The first region covers the end of the first lead. The second region covers the portion of the second lead. The third region is located between the first region and the second region.

Alternatively, the portion of the second lead covered by the second region may be an end of the second lead or may be elsewhere on the second lead.

In one possible implementation, the first lead is perpendicular to the second lead, and the first lead is parallel to the undercut structure. The above-mentioned first lead is parallel to the undercut structure, which may mean that the first lead is parallel to the extension direction of the strip-shaped undercut structure.

In embodiments of this application, in order to ensure the quantum performance of the Josephson junction and reduce the preparation difficulty, the first lead and the second lead may be set perpendicular to each other.

Alternatively, in order to accommodate varying circuit routing requirements, the first lead and the second lead may also be set to be non-perpendicular, and accordingly, the first lead and the undercut structure may also be non-parallel.

For example, referring to FIG. 6, it shows a schematic diagram of a circuit structure and undercut structure according to an embodiment of this application. As shown in FIG. 6, a first lead 61 and a second lead 62 in the circuit structure are at an angle of 45 degrees, and the two do not intersect. The undercut structure spans the first lead 61 and the second lead 62. A first region 63a (bottom of hollow-out) and a second region 63b (bottom of hollow-out) in the undercut structure cover ends of the first lead 61 and the second lead 62, and a third region 63c with an opening exists between the first region 63a and the second region 63b.

In one possible implementation, the undercut structure further includes a fourth region. The fourth region is an opening region of the undercut structure. The second region is located between the third region and the fourth region.

In one possible implementation, a length of the second region is greater than that of the first region, and the portion of the second lead covered by the second region is located on a side of the second region close to the third region.

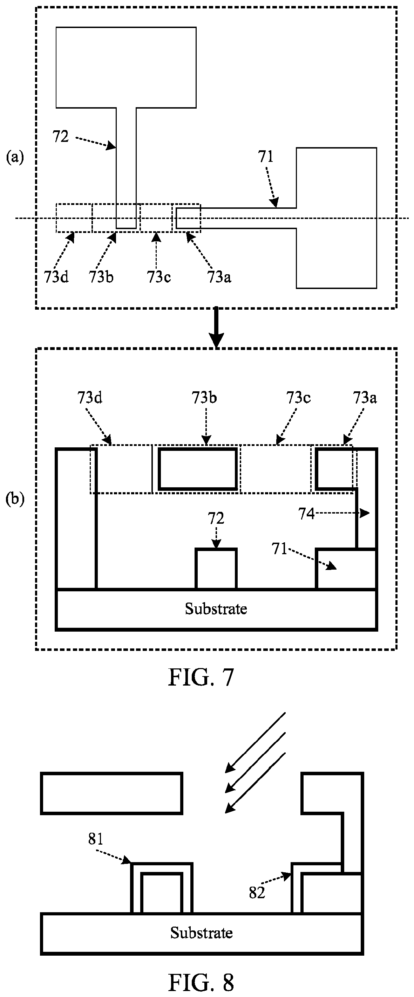

For example, referring to FIG. 7, it shows a schematic diagram of another circuit structure and undercut structure according to an embodiment of this application. As shown in portion (a) of FIG. 7, a first lead 71 and a second lead 72 in the circuit structure are at an angle of 90 degrees, and the undercut structure includes a first region 73a (bottom of hollow-out), a second region 73b (bottom of hollow-out), a third region 73c (opening region), and a fourth region 73d (opening region). The first region 73a covers an end of the first lead 71, the second region 73b covers an end of the second lead 72 and continues to the left (the other side with respect to the first region 73a), the third region 73c is located between the first region 73a and the second region 73b, and the fourth region 73d is located on the other side of the second region 73b. The end of the second lead 72 is located at one side (left side) of the second region 73b close to the first region 73a.

In embodiments of this application, after etching the underlying aluminum, an electron beam photoresist may be used, and the undercut structure is prepared in a Josephson junction region using an electron beam exposure method. The undercut structure refers to a structure with the photoresist on an upper layer and a hole on a lower layer, and a schematic diagram is shown in portion (a) of FIG. 7. In this step, photolithography may be performed using a double-layer adhesive of methyl methacrylate (MMA) and poly methyl methacrylate (PMMA), the exposure dose may be selected to be 150 µC/cm2 and 450 µC/cm2, and then development is performed using a mixture of methyl isobutyl ketone (MIBK) and isopropyl alcohol (IPA), and photographic fixing is performed using IPA. The third region 73c and the fourth region 73d in FIG. 7 represent the portions where the photoresist is developed away to expose the substrate to the environment, and the first region 73a and the second region 73b represent the undercut structure, i.e., a structure with the photoresist on the upper layer and the hole on the lower layer. The undercut structure of a portion of the first region 73a and the second region 73b coincides with the underlying aluminum of the Josephson junction (i.e., the ends of the two leads). Portion (b) of FIG. 7 corresponds to a side view of portion (a) of FIG. 7 along the dashed line. A region 74 represents a cutoff range of the undercut structure, i.e., from here further to the right is the complete photoresist.

Step 503. Perform ion etching on surfaces of the first lead and the second lead which are not covered by the photoresist.

In embodiments of this application, since the first lead and the second lead may be exposed to air after the above-mentioned circuit structure is prepared, exposed surfaces of the first lead and the second lead may undergo an oxidation reaction with oxygen in the air, thereby generating a native oxide layer. However, the native oxide layer is usually not dense enough, and the insulation performance thereof is poor, thereby affecting the insulation performance of a subsequently prepared oxide layer. In this regard, in embodiments of this application, the native oxide layer on the surfaces of the first lead and the second lead which are not covered by the photoresist may be removed by ion etching before a dense oxide layer is prepared.

In one possible implementation, the performing the ion etching on surfaces of the first lead and the second lead which are not covered by the photoresist includes:
rotating the substrate while keeping an inclination angle of the ion etching constant.

In embodiments of this application, the removal effect of the native oxide layer on the surfaces of the first lead and the second lead may be improved by keeping the inclination angle of the ion etching constant and rotating the substrate in such a way that an ion current can sufficiently enter the undercut structure.

In embodiments of this application, after the undercut structure is prepared, the plasma may be used to bombard the third region 73c and the fourth region 73d, etc. at a certain angle (for example, in an oblique left direction in FIG. 7), and an oblique angle of the ion etching may be controlled as much as possible, and at the same time, the substrate is controlled to rotate in a horizontal direction at a certain rotation speed so that the plasma can sufficiently enter the third region 73c and the fourth region 73d. This rotation speed may be selected as 10 rpm so that the plasma uniformly and completely removes the native oxide layer on the exposed portions of the first lead 71 and the second lead 72.

Step 504. Place the substrate into an oxidation chamber in the pure oxygen environment for oxidation.

This step may prepare the oxide layer on the surface of the second lead which is not covered by the photoresist.

In one possible implementation, a pressure in the oxidation chamber is 4 Torr. An oxidation duration of the substrate in the oxidation chamber is 1,000 to 2,000 seconds.

In embodiments of this application, the substrate may be sent to the oxidation chamber insitu (maintaining a vacuum environment) to perform oxidation in the pure oxygen environment. At this time, the pressure in the oxidation chamber may be set to be about 4 Torr, and the oxidation duration is 1,000 s to 2,000 s to obtain a denser oxide layer, and a desired resistance of the Josephson junction may be obtained by precisely controlling the pressure in the oxidation chamber and the oxidation duration during oxidation.

Step 505. Evaporate the first superconducting layer obliquely in the direction from the first region to the second region to obtain the Josephson junction.

The first superconducting layer covers the region on the second lead which is not covered by the photoresist and the portion of the substrate between the second lead and the first lead.

In one possible implementation, the first superconducting layer has a coating growth rate of 1 nm per second. The thickness of the first superconducting layer is 100 nm.

Referring to FIG. 8, it shows a schematic diagram of a result after oxidation according to an embodiment of this application. Superconducting films, such as the aluminum film, exposed to oxygen are oxidized. A region 81 and a region 82 represent dense aluminum oxide layers obtained after oxidation in the oxidation chamber, which is also a critical step in preparing the Josephson junction. Thereafter, an aluminum film is coated on an aluminum oxide film layer represented by a region 81 in an oblique left direction as shown in FIG. 8. The coating rate may be selected to be 1 nm/s, and the thickness of the aluminum film may be selected to be 100 nm.

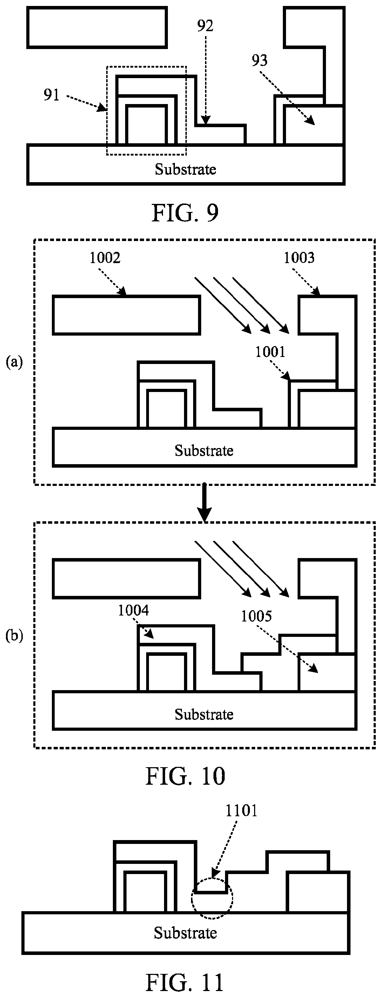

Referring to FIG. 9, it shows a diagram of an effect after evaporating the aluminum according to an embodiment of this application. As shown in FIG. 9, the aluminum-aluminum oxide-aluminum structure shown in region 91 is the resulting Josephson junction. Since, in the step shown in FIG. 8, a coating direction is along the oblique left direction, in addition to obtaining the Josephson junction, an aluminum film is newly evaporated on the substrate, as shown in a portion of a region 92 in FIG. 9, and by precisely controlling a coating angle, a newly evaporated region 92 may be relatively close to but not in contact with a region 93 (i.e., the end of the first lead), and a distance between the region 92 and the region 93 may be controlled in the order of several hundred nanometers.

Step 506. Perform ion etching obliquely in the direction from the second region to the first region.

This step may remove the oxide layer on the surface of the first lead which is not covered by the photoresist.

In one possible implementation, the performing ion etching obliquely in the direction from the second region to the first region has a duration of 2 minutes at an etching power of 200 watts.

The oxidation step shown in step 504 causes all exposed surfaces of the superconducting films (e.g., aluminum film) to form aluminum oxide when the oxidation is performed in the oxidation chamber, i.e., a region 81 and a region 82 shown in FIG. 8. The region 81 is a portion required by the solution shown in this application to form the Josephson junction, and the region 82 is required to be connected to an external circuit so that the oxide layer in this region needs to be removed, otherwise the parasitic junction will be formed, affecting bit performance. Referring to FIG. 10, it shows a schematic diagram of oxide layer removal according to an embodiment of this invention. As shown in portion (a) of FIG. 10, the aluminum oxide additionally formed at the end of the first lead is removed along the lower right direction, i.e., an oxide layer on a region 1001 is removed. At this time, the plasma bombards the aluminum oxide may be selected to be 2 min and the power may be selected to be 200 W. At the same time, since an undercut structure shown in a region 1002 is larger than an undercut structure shown in a region 1003, it is possible to ensure that the plasma does not act on the Josephson junction region while removing the aluminum oxide in the region 1001 by controlling a dip of the ion beam.

In embodiments of this application, since the plasma bombardment of the region 1001 may cause impurities to fall on the oxide layer of the junction region of the Josephson junction, thereby affecting the bit performance, the above-mentioned step 506 may also be performed after step 505.

Alternatively, the above-mentioned step 506 may also be performed before step 505 to avoid affecting the newly evaporated superconducting film layer in the region 92 in FIG. 9 by plasma bombardment of the oxide layer in the region 1001.

Step 507. Evaporate the second superconducting layer obliquely in the direction from the second region to the first region.

The second superconducting layer covers the region on the first lead which is not covered by the photoresist, the portion of the substrate between the second lead and the first lead, and the portion of the first superconducting layer.

In embodiments of this application, after the first superconducting layer is evaporated and the oxide layer on the first lead is removed, the superconducting film (aluminum film) may be evaporated along a direction obliquely downward to the right as shown in portion (b) of FIG. 10. Here, the purpose of evaporating the aluminum film is to connect a region 1004 (the first superconducting layer) and a region 1005 (the end of the first lead), and since the undercut structure shown in the region 1002 is larger than the undercut structure shown in the region 1003, the aluminum film may not be evaporated to the Josephson junction region by controlling the dip of the ion beam so that the region 1004 and the region 1005 are connected when the aluminum film is evaporated. This completes the connection of the Josephson junction to the external circuit. The coating rate of the second superconducting layer may be selected to be 1 nm/s, and the thickness of the aluminum film may be selected to be 100 nm.

Referring to FIG. 11, it shows a schematic diagram of a Josephson junction region according to an embodiment of this application. As shown in FIG. 11, the quantum computing device obtained by the solution shown in embodiments of this application has only the aluminum oxide film on the Josephson junction, and other regions do not have the parasitic junction. And only the substrate in a very small region shown in the region 1101 is bombarded by the plasma, so an influence of substrate damage on the bit performance may be obviously reduced.

In summary, in the solution shown in embodiments of this application, in the preparation of the quantum computing device, firstly, the peripheral circuit of the Josephson junction and leads connecting the Josephson junction with the peripheral circuit are prepared by nano-imprinting, and the leads and the peripheral circuit are of an integral structure so that the subsequently prepared Josephson junction does not need to additionally prepare a Josephson junction patch/Josephson junction bandage to connect with the peripheral circuit. Then, the first superconducting layer and the second superconducting layer are prepared by evaporation of superconducting materials in two inclined directions through the undercut structure. The first superconducting layer forms the Josephson junction at the intersection with the second lead, and the second superconducting layer connects the first superconducting layer and the end of the first lead, thereby performing a superconducting connection between the end of the first lead and the Josephson junction. When the Josephson junction in the quantum computing device is prepared by the above-mentioned solution, the introduction of the parasitic junction may be avoided to improve the coherence time of the qubit component, thereby improving the performance of the quantum computing device.

The basic idea of this application is to first prepare a large circuit structure and an underlying aluminum structure of the Josephson junction at once using the nano-imprinting method. Because the nano-imprinting method may achieve resolutions of several nanometers and belongs to mechanical imprinting, very large areas of structures may be rapidly imprinted so that circuit structures in the order of micrometers and Josephson junctions in the order of nanometers may be prepared on the same mask plate.

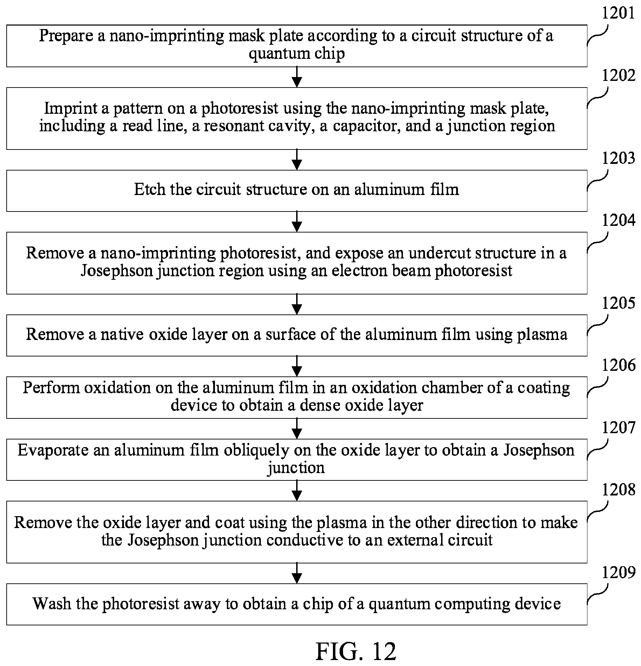

FIG. 12 is a flowchart of the preparation of a quantum computing device according to an exemplary embodiment of this application. As shown in FIG. 12, a basic flow for preparing the quantum computing device may be as follows.

S1201. Prepare the nano-imprinting mask plate firstly according to the circuit structure of the quantum chip.

S1202. Imprint the pattern on the photoresist using the nano-imprinting mask plate, including the read line, the resonant cavity, the capacitor, and a junction region.

Since the nano-imprinting uses mechanical pressure to imprint a groove structure on the photoresist, there is obvious photoresist residue at the bottom of the groove. Later, the remaining photoresist at the bottom of the groove is removed using a plasma degumming device.

S1203. Etch the circuit structure on the aluminum film, including a micrometer-scale circuit with a large size, such as the read line, the resonant cavity, and the capacitor, and a nanometer-scale circuit with a small size, such as the underlying aluminum of the Josephson junction, where dry etching or wet etching may be used.

S1204. Remove the nano-imprinting photoresist, and expose the undercut structure in the Josephson junction region using the electron beam photoresist.

S1205. Remove the native oxide layer on the surface of the aluminum film in a coating device using the plasma after preparing the undercut structure, because the surface of the aluminum film is extremely easy to oxidize in air. The substrate may be controlled to rotate at a certain rotation speed in this step so that the removal process of the oxide layer is more uniform and complete.

S1206. Perform oxidation on the aluminum film in the oxidation chamber of the coating device to obtain the dense oxide layer.

S1207. Evaporate an aluminum film obliquely on the oxide layer to obtain the Josephson junction.

S1208. Remove the oxide layer and coat using the plasma in the other direction to make the Josephson junction conductive to the external circuit.

S1209. Wash the photoresist away to obtain the chip of the quantum computing device.

In the solution shown in embodiments of this application, the large circuit structure and the underlying aluminum of the Josephson junction are prepared at once by nano-imprinting so that the parasitic junction generated during preparing the quantum computing device may be avoided and the influence on the bit performance may be reduced.

At present, the commonly used method for preparing the underlying aluminum of the Josephson junction is the liftoff method, and the solutions shown in various embodiments of this application use the etching method to prepare the structure of the underlying aluminum of the Josephson junction, which may improve the quality of the quantum computing device.

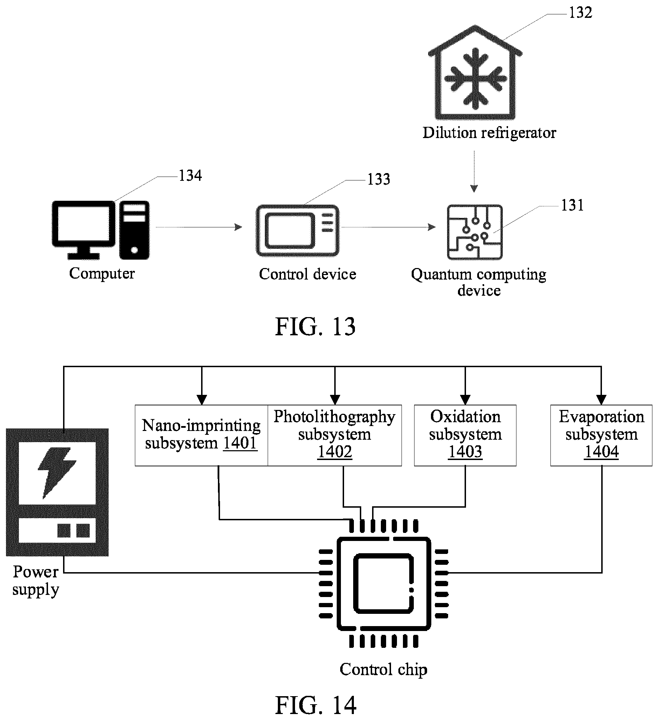

Referring to FIG. 13, it shows a schematic diagram of a product application scene according to an embodiment of this application. As shown in FIG. 13, the product of the quantum computing device (such as the quantum computing chip) prepared by embodiments of this application may be applied to the application scene shown in FIG. 13. This application scene may be a superconducting quantum computing platform, and includes: a quantum computing device 131, a dilution refrigerator 132, a control device 133, and a computer 134.

The quantum computing device 131 is a circuit acting on a physical qubit and may be realized as the quantum chip, such as a superconducting quantum chip in the vicinity of absolute zero. The dilution refrigerator 132 is configured to provide an absolute zero environment for the superconducting quantum chip. The above-mentioned physical qubit may be the Josephson junction prepared by the method shown in the above-mentioned embodiments of this application.

The control device 133 is configured to control the quantum computing device 131, and the computer 134 is configured to control the control device 133. For example, a programmed quantum program is compiled into an instruction via software in the computer 134 and sent to the control device 133 (e.g., an electronic/microwave control system). The control device 133 converts the above-mentioned instruction into an electronic/microwave control signal and inputs them to the dilution refrigerator 132 to control the superconducting qubit at a temperature of less than 10 mK. The process of reading is reversed, and a read waveform is transmitted to the quantum computing device 131.

FIG. 14 shows a schematic diagram of a system for preparing a Josephson junction according to an exemplary embodiment of this application, and the system for preparing a Josephson junction may be implemented as the production line device. As shown in FIG. 14, the system for preparing a Josephson junction includes: a nano-imprinting subsystem 1401, a photolithography subsystem 1402, an oxidation subsystem 1403, and an evaporation subsystem 1404.

The nano-imprinting subsystem 1401 is configured to prepare the circuit structure on the substrate by nano-imprinting. The circuit structure includes the first lead, the second lead, and the peripheral circuit connected to the first lead and the second lead. The first lead, the second lead, and the peripheral circuit are of an integral structure.

In one possible implementation, the extension line of the first lead intersects the second lead.

The above-mentioned nano-imprinting subsystem 1401 may include a spin coater (configured to spin coat the nano-imprinting adhesive), a nano-imprinting imprinter (configured to imprint the circuit pattern), an adhesive remover (configured to remove the nano-imprinting adhesive), an etcher (configured to etch the superconducting film layer), etc.

The photolithography subsystem 1402 is configured to prepare the photoresist-based undercut structure on the substrate. The undercut structure is a strip-shaped structure, and the undercut structure includes the first region, the second region, and the third region connected between the first region and the second region. The first region and the second region have upper photoresist layers and lower layers of hollow-out. The second region is the opening region of the undercut structure. The first region covers the end of the first lead. The second region covers the portion of the second lead. The third region is located between the first region and the second region.

The above-mentioned photolithography subsystem 1402 may include the spin coater (configured to spin coat the photoresist), a photolithography machine (configured to perform photolithography on the photoresist), a developing device (configured to expose and develop the photoresist after photolithography), a cleaner (configured to clean residual exposed photoresist), etc.

The oxidation subsystem 1403 is configured to prepare the oxide layer on the surface of the second lead which is not covered by the photoresist.

The above-mentioned oxidation subsystem 1403 may include the oxidation chamber.

The evaporation subsystem 1404 is configured to evaporate the first superconducting layer obliquely in the direction from the first region to the second region to obtain the Josephson junction. The first superconducting layer covers the region on the second lead which is not covered by the photoresist and the portion of the substrate between the second lead and the first lead.

The evaporation subsystem 1404 is further configured to evaporate the second superconducting layer obliquely in the direction from the second region to the first region. The second superconducting layer covers the region on the first lead which is not covered by the photoresist, the portion of the substrate between the second lead and the first lead, and the portion of the first superconducting layer.

The above-mentioned evaporation subsystem 1404 may include the evaporator (configured to evaporate the superconducting material).

In one possible implementation, the undercut structure further includes the fourth region. The fourth region is the opening region of the undercut structure. The second region is located between the third region and the fourth region.

In one possible implementation, the length of the second region is greater than that of the first region, and the portion of the second lead covered by the second region is located on the side of the second region close to the third region.

In one possible implementation, the oxidation subsystem is configured to place the substrate into the oxidation chamber in the pure oxygen environment for oxidation.

The system for preparing a Josephson junction further includes: an etching subsystem, configured to perform ion etching obliquely in the direction from the second region to the first region to remove the oxide layer on the surface of the first lead which is not covered by the photoresist.

In one possible implementation, the performing ion etching obliquely in the direction from the second region to the first region has the duration of 2 minutes at the etching power of 200 watts.

In one possible implementation, the pressure in the oxidation chamber is 4 Torr. The oxidation duration of the substrate in the oxidation chamber is 1,000 to 2,000 seconds.

In one possible implementation, the etching subsystem is further configured to performing the ion etching on surfaces of the first lead and the second lead which are not covered by the photoresist.

In one possible implementation, the etch subsystem is configured to rotate the substrate while keeping the inclination angle of the ion etching constant.

In one possible implementation, the first superconducting layer has the coating growth rate of 1 nm per second. The thickness of the first superconducting layer is 100 nm.

In one possible implementation, the first lead is perpendicular to the second lead, and the first lead is parallel to the undercut structure.

In one possible implementation, the nano-imprinting subsystem 1401 is configured to,
prepare the superconducting film layer on the substrate;
spin coat nano-imprinting adhesive on the superconducting film layer;
imprint the structure pattern of the circuit structure on the nano-imprinting adhesive through the nano-imprinting mask plate;
etch on the superconducting film layer based on the structure pattern; and
wash the nano-imprinting adhesive on the substrate to obtain the circuit structure located on the substrate.

In one possible implementation, the thickness of the superconducting film layer is 100 nm.

In one possible implementation, the nano-imprinting subsystem 1401 is configured to etch on the superconducting film layer based on the structure pattern by dry etching.

In one possible implementation, the nano-imprinting subsystem 1401 is further configured to remove nano-imprinting adhesive remaining in the imprint groove of the nano-imprinting adhesive.

Alternatively, spatial connections between the subsystems and between machines in the subsystems are performed through a conveyor belt, or a movement of the preparation between the machines is done based on a mechanical arm.

Alternatively, the system for preparing a Josephson junction further includes a memory configured to store at least one computer instruction. A processor executes the at least one computer instruction to cause the system for preparing a Josephson junction to perform the above-mentioned method for preparing a Josephson junction.

In summary, in the solution shown in embodiments of this application, in the preparation of the quantum computing device, firstly, the peripheral circuit of the Josephson junction and leads connecting the Josephson junction with the peripheral circuit are prepared by nano-imprinting, and the leads and the peripheral circuit are of an integral structure so that the subsequently prepared Josephson junction does not need to additionally prepare a Josephson junction patch/Josephson junction bandage to connect with the peripheral circuit. Then, the first superconducting layer and the second superconducting layer are prepared by evaporation of superconducting materials in two inclined directions through the undercut structure. The first superconducting layer forms the Josephson junction at the intersection with the second lead, and the second superconducting layer connects the first superconducting layer and the end of the first lead, thereby performing a superconducting connection between the end of the first lead and the Josephson junction. When the Josephson junction in the quantum computing device is prepared by the above-mentioned solution, the introduction of the parasitic junction may be avoided to improve the coherence time of the qubit component, thereby improving the performance of the quantum computing device.

In one exemplary embodiment, a computer-readable storage medium having stored therein at least one computer instruction is also provided. The at least one computer instruction is executed by a processor in the system for preparing a Josephson junction to cause the system for preparing a Josephson junction to perform the above-mentioned method for preparing a Josephson junction.

In an exemplary embodiment, a computer program product or computer program including the computer instruction is also provided. The computer instruction is stored in the computer-readable storage medium. A processor of the production line device reads the computer instruction from the computer-readable storage medium, and the processor executes the computer instruction to cause the system for preparing a Josephson junction to perform the above-mentioned method for preparing a Josephson junction.

## Claims

1. A method for preparing a Josephson junction, performed by a production line device, comprising:
preparing (201; 501) a circuit structure on a substrate by nano-imprinting; the circuit structure comprising a first lead (31; 41; 61; 71), a second lead (32; 42; 62; 72), and
a peripheral circuit connected to the first lead (31; 41; 61; 71) and the second lead (32; 42; 62; 72); and the first lead (31; 41; 61; 71), the second lead (32; 42; 62; 72), and the peripheral circuit being of an integral structure;
preparing (202; 502) a photoresist-based undercut structure on the substrate; the undercut structure being a strip-shaped structure, and the undercut structure comprising a first region (33; 44; 63a; 73a), a second region (35; 45; 63b; 73b), and a third region (34; 46; 63c; 73c) connected between the first region (33; 44; 63a; 73a) and the second region (35; 45; 63b; 73b); the first region (33; 44; 63a; 73a) and the second region (35; 45; 63b; 73b) having upper photoresist layers and lower layers of hollow-out; the third region (34; 46; 63c; 73c) being an opening region of the undercut structure; the first region (33; 44; 63a; 73a) covering an end of the first lead (31; 61; 71); the second region (35; 45; 63b; 73b) covering a portion of the second lead (32; 62; 72); and the third region (34; 46; 63c; 73c) being located between the first region (33; 44; 63a; 73a) and the second region (35; 45; 63b; 73b);
preparing (203) an oxide layer (47) on a surface of the second lead (32; 42; 62; 72) which is not covered by the photoresist;
evaporating (204; 505) a first superconducting layer (48) obliquely in a direction from the first region (33; 44; 63a; 73a) to the second region (35; 45; 63b; 73b) to obtain the Josephson junction; and the first superconducting layer (48) covering a region on the second lead (32; 42; 62; 72) which is not covered by the photoresist and a portion of the substrate between the second lead (32; 42; 62; 72) and the first lead (31; 41; 61; 71); and
evaporating (205; 507) a second superconducting layer (49) obliquely in a direction from the second region (35; 45; 63b; 73b) to the first region (33; 44; 63a; 73a); and the second superconducting layer (49) covering a region on the first lead (31; 41; 61; 71) which is not covered by the photoresist, the portion of the substrate between the second lead (32; 42; 62; 72) and the first lead (31; 41; 61; 71), and a portion of the first superconducting layer (48).

2. The method according to claim 1, wherein the undercut structure further comprises a fourth region (73d); the fourth region (73d) is an opening region of the undercut structure; and the second region (35; 45; 63b; 73b) is located between the third region (34; 46; 63c; 73c) and the fourth region (73d).

3. The method according to claim 2, wherein a length of the second region (35; 45; 63b; 73b) is greater than that of the first region (33; 44; 63a; 73a), and the portion of the second lead (32; 42; 62; 72) covered by the second region (35; 45; 63b; 73b) is located on a side of the second region (35; 45; 63b; 73b) close to the third region (34; 46; 63c; 73c).

4. The method according to any one of claims 1 to 3, wherein the preparing (203) an oxide layer (47) on a surface of the second lead (32; 42; 62; 72) which is not covered by the photoresist comprises:
placing (504) the substrate into an oxidation chamber in a pure oxygen environment for oxidation; and
the method further comprises:
before evaporating (507) a second superconducting layer (49) obliquely in a direction from the second region (35; 45; 63b; 73b) to the first region (33; 44; 63a; 73a) to obtain the Josephson junction, further comprising:
performing (506) ion etching obliquely in the direction from the second region (35; 45; 63b; 73b) to the first region (33; 44; 63a; 73a) to remove an oxide layer (47) on a surface of the first lead (31; 41; 61; 71) which is not covered by the photoresist.

5. The method according to claim 4, wherein the performing ion etching obliquely in the direction from the second region (35; 45; 63b; 73b) to the first region (33; 44; 63a; 73a) has a duration of 2 minutes at an etching power of 200 watts; or, a pressure in the oxidation chamber is 4 Torr; and an oxidation duration of the substrate in the oxidation chamber is 1,000 to 2,000 seconds.

6. The method according to any one of claims 1 to 3, wherein before the preparing (203) an oxide layer (47) on a surface of the second lead (32; 42; 62; 72) which is not covered by the photoresist, the method further comprises:
performing (503) ion etching on surfaces of the first lead (31; 41; 61; 71) and the second lead (32; 42; 62; 72) which are not covered by the photoresist.

7. The method according to claim 6, wherein the performing the ion etching on surfaces of the first lead (31; 41; 61; 71) and the second lead (32; 42; 62; 72) which are not covered by the photoresist comprises:
rotating the substrate while keeping an inclination angle of the ion etching constant.

8. The method according to any one of claims 1 to 3, wherein the first superconducting layer (48) has a coating growth rate of 1 nm per second, and a thickness of the first superconducting layer (48) is 100 nm; and an extension line of the first lead (31; 41; 61; 71) intersects the second lead (32; 42; 62; 72).

9. The method according to claim 8, wherein when the extension line of the first lead (31; 41; 61; 71) intersects the second lead (32; 42; 62; 72), the first lead (31; 41; 61; 71) is perpendicular to the second lead (32; 42; 62; 72), and the first lead (31; 41; 61; 71) is parallel to the undercut structure.

10. The method according to any one of claims 1 to 3, wherein the preparing a circuit structure on a substrate by nano-imprinting comprises:
preparing a superconducting film layer on the substrate;
spin coating nano-imprinting adhesive on the superconducting film layer;
imprinting a structure pattern of the circuit structure on the nano-imprinting adhesive through a nano-imprinting mask plate;
etching on the superconducting film layer based on the structure pattern; and
washing the nano-imprinting adhesive on the substrate to obtain the circuit structure located on the substrate,
wherein a thickness of the superconducting film layer is 100 nm.

11. The method according to claim 10, wherein the etching on the superconducting film layer based on the structure pattern comprises:
etching on the superconducting film layer based on the structure pattern by dry etching; or,
wherein before the etching on the superconducting film layer based on the structure pattern, the method further comprises:
removing nano-imprinting adhesive remaining in an imprint groove of the nano-imprinting adhesive.

12. A system for preparing a Josephson junction, the system comprising: a nano-imprinting subsystem (1401), a photolithography subsystem (1402), an oxidation subsystem (1403), and an evaporation subsystem (1404); wherein
the nano-imprinting subsystem (1401) is configured to prepare a circuit structure on a substrate by nano-imprinting; the circuit structure comprising a first lead (31; 41; 61; 71), a second lead (32; 42; 62; 72), and a peripheral circuit connected to the first lead (31; 41; 61; 71) and the second lead (32; 42; 62; 72); and the first lead (31; 41; 61; 71), the second lead (32; 42; 62; 72), and the peripheral circuit being of an integral structure;
the photolithography subsystem (1402) is configured to prepare a photoresist-based undercut structure on the substrate; the undercut structure being a strip-shaped structure, and the undercut structure comprising a first region (33; 44; 63a; 73a), a second region (35; 45; 63b; 73b), and a third region (34; 46; 63c; 73c) connected between the first region (33; 44; 63a; 73a) and the second region (35; 45; 63b; 73b); the first region (33; 44; 63a; 73a) and the second region (35; 45; 63b; 73b) having upper photoresist layers and lower layers of hollow-out; the third region (34; 46; 63c; 73c) being an opening region of the undercut structure; the first region (33; 44; 63a; 73a) covering an end of the first lead (31; 41; 61; 71); the second region (35; 45; 63b; 73b) covering a portion of the second lead (32; 42; 62; 72); and the third region (34; 46; 63c; 73c) being located between the first region (33; 44; 63a; 73a) and the second region (35; 45; 63b; 73b);
the oxidation subsystem (1403) is configured to prepare an oxide layer (47) on a surface of the second lead (32; 42; 62; 72) which is not covered by the photoresist;
the evaporation subsystem (1404) is configured to evaporate a first superconducting layer (48) obliquely in a direction from the first region (33; 44; 63a; 73a) to the second region to obtain the Josephson junction; and the first superconducting layer (48) covering a region on the second lead (32; 42; 62; 72) which is not covered by the photoresist and a portion of the substrate between the second lead (32; 42; 62; 72) and the first lead (31; 41; 61; 71); and
the evaporation subsystem (1404) is further configured to evaporate a second superconducting layer (49) obliquely in a direction from the second region (35; 45; 63b; 73b) to the first region (33; 44; 63a; 73a); and the second superconducting layer (49) covering a region on the first lead (31; 41; 61; 71) which is not covered by the photoresist, the portion of the substrate between the second lead (32; 42; 62; 72) and
the first lead (31; 41; 61; 71), and a portion of the first superconducting layer (48),

13. The system for preparing a Josephson junction according to claim 12, wherein the undercut structure further comprises a fourth region (73d); the fourth region (73d) is an opening region of the undercut structure; and the second region (35; 45; 63b; 73b) is located between the third region (34; 46; 63c; 73c) and the fourth region (73d).

14. The system for preparing a Josephson junction according to claim 13, wherein a length of the second region (35; 45; 63b; 73b) is greater than that of the first region (33; 44; 63a; 73a), and the portion of the second lead (32; 42; 62; 72) covered by the second region (35; 45; 63b; 73b) is located on a side of the second region (35; 45; 63b; 73b) close to the third region (34; 46; 63c; 73c).

15. The system for preparing a Josephson junction according to any one of claims 12 to 14, wherein the oxidation subsystem (1403) is configured to place the substrate into an oxidation chamber in a pure oxygen environment for oxidation;
the system for preparing a Josephson junction further comprises: an etching subsystem, configured to perform ion etching obliquely in the direction from the second region (35; 45; 63b; 73b) to the first region (33; 44; 63a; 73a) to remove an oxide layer (47) on a surface of the first lead (31; 41; 61; 71) which is not covered by the photoresist.

## Patentansprüche

1. Verfahren zur Herstellung eines Josephson-Übergangs, das von einer Fertigungslinienvorrichtung durchgeführt wird, umfassend:
Herstellen (201; 501) einer Schaltungsstruktur auf einem Substrat durch Nanoprägen;
wobei die Schaltungsstruktur eine erste Leitung (31; 41; 61; 71), eine zweite Leitung (32; 42; 62; 72) und eine periphere Schaltung umfasst, die mit der ersten Leitung (31; 41; 61; 71) und der zweiten Leitung (32; 42; 62; 72) verbunden ist;
und die erste Leitung (31; 41; 61; 71), die zweite Leitung (32; 42; 62; 72) und die periphere Schaltung von einer einteiligen Struktur sind;
Herstellen (202; 502) einer Unterschnittstruktur auf Photoresist-Basis auf dem Substrat;
wobei die Unterschnittstruktur eine streifenförmige Struktur ist, und die Unterschnittstruktur eine erste Region (33; 44; 63a; 73a), eine zweite Region (35; 45; 63b; 73b) und eine dritte Region (34; 46; 63c; 73c) umfasst, die zwischen der ersten Region (33; 44; 63a; 73a) und der zweiten Region (35; 45; 63b; 73b) verbunden ist; wobei die erste Region (33; 44; 63a; 73a) und die zweite Region (35; 45; 63b; 73b) obere Photoresist-Schichten und untere Aushöhlungsschichten aufweisen; wobei die dritte Region (34; 46; 63c; 73c) eine Öffnungsregion der Unterschnittstruktur ist; wobei die erste Region (33; 44; 63a; 73a) ein Ende der ersten Leitung (31; 61; 71) bedeckt; wobei die zweite Region (35; 45; 63b; 73b) einen Abschnitt der zweiten Leitung (32; 62; 72) bedeckt; und wobei die dritte Region (34; 46; 63c; 73c) sich zwischen der ersten Region (33; 44; 63a; 73a) und der zweiten Region (35; 45; 63b; 73b) befindet;
Herstellen (203) einer Oxidschicht (47) auf einer Oberfläche der zweiten Leitung (32; 42; 62; 72), die nicht von dem Photoresist bedeckt ist;
Verdampfen (204; 505) einer ersten supraleitenden Schicht (48) schräg in einer Richtung von der ersten Region (33; 44; 63a; 73a) zur zweiten Region (35; 45; 63b; 73b), um den Josephson-Übergang zu erhalten; und wobei die erste supraleitende Schicht (48) eine Region auf der zweiten Leitung (32; 42; 62; 72), die nicht von dem Photoresist bedeckt ist, und einen Abschnitt des Substrats zwischen der zweiten Leitung (32; 42; 62; 72) und der ersten Leitung (31; 41; 61; 71) bedeckt; und
Verdampfen (205; 507) einer zweiten supraleitenden Schicht (49) schräg in einer Richtung von der zweiten Region (35; 45; 63b; 73b) zu der ersten Region (33; 44; 63a; 73a); und wobei die zweite supraleitende Schicht (49) eine Region auf der ersten Leitung (31; 41; 61; 71), die nicht von dem Photoresist bedeckt ist, den Abschnitt des Substrats zwischen der zweiten Leitung (32; 42; 62; 72) und der ersten Leitung (31; 41; 61; 71) und einen Abschnitt der ersten supraleitenden Schicht (48) bedeckt.

2. Verfahren nach Anspruch 1, wobei die Unterschnittstruktur ferner eine vierte Region (73d) umfasst; wobei die vierte Region (73d) eine Öffnungsregion der Unterschnittstruktur ist; und die zweite Region (35; 45; 63b; 73b) sich zwischen der dritten Region (34; 46; 63c; 73c) und der vierten Region (73d) befindet.

3. Verfahren nach Anspruch 2, wobei eine Länge der zweiten Region (35; 45; 63b; 73b) größer als diejenige der ersten Region (33; 44; 63a; 73a) ist, und der Abschnitt der zweiten Leitung (32; 42; 62; 72), der von der zweiten Region (35; 45; 63b; 73b) bedeckt ist, sich auf einer Seite der zweiten Region (35; 45; 63b; 73b) befindet, die nahe an der dritten Region (34; 46; 63c; 73c) liegt.

4. Verfahren nach einem der Ansprüche 1 bis 3, wobei das Herstellen (203) einer Oxidschicht (47) auf einer Oberfläche der zweiten Leitung (32; 42; 62; 72), die nicht von dem Photoresist bedeckt ist, umfasst:
Platzieren (504) des Substrats in einer Oxidationskammer in einer reinen Sauerstoffumgebung zur Oxidation; und
das Verfahren ferner umfasst:
vor dem Verdampfen (507) einer zweiten supraleitenden Schicht (49) schräg in einer Richtung von der zweiten Region (35; 45; 63b; 73b) zur ersten Region (33; 44; 63a; 73a) zum Erhalten des Josephson-Übergangs, ferner umfassend:
Durchführen (506) von Ionenätzen schräg in der Richtung von der zweiten Region (35; 45; 63b; 73b) zur ersten Region (33; 44; 63a; 73a), um eine Oxidschicht (47) auf einer Oberfläche der ersten Leitung (31; 41; 61; 71) zu entfernen, die nicht von dem Photoresist bedeckt ist.

5. Verfahren nach Anspruch 4, wobei das Durchführen von Ionenätzen schräg in der Richtung von der zweiten Region (35; 45; 63b; 73b) zur ersten Region (33; 44; 63a; 73a) eine Dauer von 2 Minuten bei einer Ätzleistung von 200 Watt aufweist; oder ein Druck in der Oxidationskammer 4 Torr beträgt; und eine Oxidationsdauer des Substrats in der Oxidationskammer 1000 bis 2000 Sekunden beträgt.

6. Verfahren nach einem der Ansprüche 1 bis 3, wobei vor dem Herstellen (203) einer Oxidschicht (47) auf einer Oberfläche der zweiten Leitung (32; 42; 62; 72), die nicht von dem Photoresist bedeckt ist, das Verfahren ferner umfasst:
Durchführen (503) von Ionenätzen auf Oberflächen der ersten Leitung (31; 41; 61; 71) und der zweiten Leitung (32; 42; 62; 72), die nicht von dem Photoresist bedeckt sind.

7. Verfahren nach Anspruch 6, wobei das Durchführen des Ionenätzens auf Oberflächen der ersten Leitung (31; 41; 61; 71) und der zweiten Leitung (32; 42; 62; 72), die nicht von dem Photoresist bedeckt sind, umfasst:
Drehen des Substrats und dabei Konstanthalten eines Neigungswinkels der Ionenätz.

8. Verfahren nach einem der Ansprüche 1 bis 3, wobei die erste supraleitende Schicht (48) eine Beschichtungswachstumsrate von 1 nm pro Sekunde aufweist, und eine Dicke der ersten supraleitenden Schicht (48) 100 nm beträgt; und eine Verlängerungslinie der ersten Leitung (31; 41; 61; 71) die zweite Leitung (32; 42; 62; 72) schneidet.

9. Verfahren nach Anspruch 8, wobei, wenn die Verlängerungslinie der ersten Leitung (31; 41; 61; 71) die zweite Leitung (32; 42; 62; 72) schneidet, die erste Leitung (31; 41; 61; 71) senkrecht zur zweiten Leitung (32; 42; 62; 72) ist und die erste Leitung (31; 41; 61; 71) parallel zur Unterschnittstruktur ist.

10. Verfahren nach einem der Ansprüche 1 bis 3, wobei das Herstellen einer Schaltungsstruktur auf einem Substrat durch Nanoprägen umfasst:
Herstellen einer supraleitenden Filmschicht auf dem Substrat;
Aufschleudern von Nanoprägungshaftmittel auf der supraleitenden Filmschicht;
Aufprägen eines Strukturmusters der Schaltungsstruktur auf dem Nanoprägungshaftmittel durch eine Nanoprägungsmaskenplatte;
Ätzen auf der supraleitenden Filmschicht basierend auf dem Strukturmuster; und
Waschen des Nanoprägungshaftmittels auf dem Substrat, um die Schaltungsstruktur zu erhalten, die sich auf dem Substrat befindet,
wobei eine Dicke der supraleitenden Filmschicht 100 nm beträgt.

11. Verfahren nach Anspruch 10, wobei das Ätzen auf der supraleitenden Filmschicht basierend auf dem Strukturmuster umfasst:
Ätzen auf der supraleitenden Filmschicht basierend auf dem Strukturmuster durch Trockenätzen; oder
wobei vor dem Ätzen auf der supraleitenden Filmschicht basierend auf dem Strukturmuster das Verfahren ferner umfasst:
Entfernen von Nanoprägungshaftmittel, das in einer Aufprägungsrille des Nanoprägungshaftmittels verbleibt.

12. System zur Herstellung eines Josephson-Übergangs, wobei das System umfasst: ein Nanoprägungsteilsystem (1401), ein Photolithographie-Teilsystem (1402), ein Oxidationsteilsystem (1403); und ein Verdampfungsteilsystem (1404); wobei
das Nanoprägungsteilsystem (1401) dazu ausgestaltet ist, eine Schaltungsstruktur auf einem Substrat durch Nanoprägung herzustellen;
wobei die Schaltungsstruktur eine erste Leitung (31; 41; 61; 71), eine zweite Leitung (32; 42; 62; 72) und eine periphere Schaltung umfasst, die mit der ersten Leitung (31; 41; 61; 71) und der zweiten Leitung (32; 42; 62; 72) verbunden ist; und die erste Leitung (31; 41; 61; 71), die zweite Leitung (32; 42; 62; 72) und die periphere Schaltung von einer einteiligen Struktur sind;
das Photolithographie-Teilsystem (1402) dazu ausgestaltet ist, eine Unterschnittstruktur auf Photoresist-Basis auf dem Substrat herzustellen; die Unterschnittstruktur eine streifenförmige Struktur ist, und die Unterschnittstruktur eine erste Region (33; 44; 63a; 73a), eine zweite Region (35; 45; 63b; 73b) und eine dritte Region (34; 46; 63c; 73c) umfasst, die zwischen der ersten Region (33; 44; 63a; 73a) und der zweiten Region (35; 45; 63b; 73b) verbunden ist; wobei die erste Region (33; 44; 63a; 73a) und die zweite Region (35; 45; 63b; 73b) obere Photoresist-Schichten und untere Aushöhlungsschichten aufweisen; wobei die dritte Region (34; 46; 63c; 73c) eine Öffnungsregion der Unterschnittstruktur ist; wobei die erste Region (33; 44; 63a; 73a) ein Ende der ersten Leitung (31; 41; 61; 71) bedeckt; wobei die zweite Region (35; 45; 63b; 73b) einen Abschnitt der zweiten Leitung (32; 42; 62; 72) bedeckt; und wobei die dritte Region (34; 46; 63c; 73c) sich zwischen der ersten Region (33; 44; 63a; 73a) und der zweiten Region (35; 45; 63b; 73b) befindet;
das Oxidationsteilsystem (1403) dazu ausgestaltet ist, eine Oxidschicht (47) auf einer Oberfläche der zweiten Leitung (32; 42; 62; 72) herzustellen, die nicht von dem Photoresist bedeckt ist;
das Verdampfungsteilsystem (1404) dazu ausgestaltet ist, eine erste supraleitende Schicht (48) schräg in einer Richtung von der ersten Region (33; 44; 63a; 73a) zur zweiten Region zu verdampfen, um den Josephson-Übergang zu erhalten;
und die erste supraleitende Schicht (48) eine Region auf der zweiten Leitung (32; 42; 62; 72), die nicht von dem Photoresist bedeckt ist, und einen Abschnitt des Substrats zwischen der zweiten Leitung (32; 42; 62; 72) und der ersten Leitung (31; 41; 61; 71) bedeckt; und
das Verdampfungsteilsystem (1404) ferner dazu ausgestaltet ist, eine zweite supraleitende Schicht (49) schräg in einer Richtung von der zweiten Region (35; 45; 63b; 73b) zur ersten Region (33; 44; 63a; 73a) zu verdampfen;
und die zweite supraleitende Schicht (49) eine Region auf der ersten Leitung (31; 41; 61; 71), die nicht von dem Photoresist bedeckt ist, den Abschnitt des Substrats zwischen der zweiten Leitung (32; 42; 62; 72) und der ersten Leitung (31; 41; 61; 71) und einen Abschnitt der ersten supraleitenden Schicht (48) bedeckt.

13. System zur Herstellung eines Josephson-Übergangs nach Anspruch 12, wobei die Unterschnittstruktur ferner eine vierte Region (73d) umfasst; wobei die vierte Region (73d) eine Öffnungsregion der Unterschnittstruktur ist; und die zweite Region (35; 45; 63b; 73b) sich zwischen der dritten Region (34; 46; 63c; 73c) und der vierten Region (73d) befindet.

14. System zur Herstellung eines Josephson-Übergangs nach Anspruch 13, wobei eine Länge der zweiten Region (35; 45; 63b; 73b) größer als diejenige der ersten Region (33; 44; 63a; 73a) ist, und der Abschnitt der zweiten Leitung (32; 42; 62; 72), der von der zweiten Region (35; 45; 63b; 73b) bedeckt ist, sich auf einer Seite der zweiten Region (35; 45; 63b; 73b) befindet, die nahe an der dritten Region (34; 46; 63c; 73c) liegt.

15. System zur Herstellung eines Josephson-Übergangs nach einem der Ansprüche 12 bis 14, wobei das Oxidationsteilsystem (1403) dazu ausgestaltet ist, das Substrat in einer Oxidationskammer in einer reinen Sauerstoffumgebung zur Oxidation zu platzieren;
das System zur Herstellung eines Josephson-Übergangs ferner umfasst: ein Ätzteilsystem, das dazu ausgestaltet ist, Ionenätzen schräg in der Richtung von der zweiten Region (35; 45; 63b; 73b) zur ersten Region (33; 44; 63a; 73a) durchzuführen, um eine Oxidschicht (47) auf einer Oberfläche der ersten Leitung (31; 41; 61; 71) zu entfernen, die nicht von dem Photoresist bedeckt ist.

## Revendications

1. Procédé pour préparer une jonction Josephson, effectué par un dispositif de ligne de production, comprenant :
la préparation (201 ; 501) d'une structure de circuit sur un substrat par nano-impression ; la structure de circuit comprenant un premier fil (31 ; 41 ; 61 ; 71), un deuxième fil (32 ; 42 ; 62 ; 72) et un circuit périphérique connecté au premier fil (31 ; 41 ; 61 ; 71) et au deuxième fil (32 ; 42 ; 62 ; 72) ; et le premier fil (31 ; 41 ; 61 ; 71), le deuxième fil (32 ; 42 ; 62 ; 72) et le circuit périphérique ayant une structure solidaire ;
la préparation (202 ; 502) d'une structure de contre-dépouille à base de réserve photographique sur le substrat ; la structure de contre-dépouille étant une structure en forme de bande, et la structure de contre-dépouille comprenant une première région (33 ; 44 ; 63a ; 73a), une deuxième région (35 ; 45 ; 63b ; 73b) et une troisième région (34 ; 46 ; 63c ; 73c) connectée entre la première région (33 ; 44 ; 63a ; 73a) et la deuxième région (35 ; 45 ; 63b ; 73b) ; la première région (33 ; 44 ; 63a ; 73a) et la deuxième région (35 ; 45 ; 63b ; 73b) ayant des couches de réserve photographique supérieures et des couches inférieures de creux-dehors ; la troisième région (34 ; 46 ; 63c ; 73c) étant une région d'ouverture de la structure de contre-dépouille ; la première région (33 ; 44 ; 63a ; 73a) couvrant une extrémité du premier fil (31 ; 61 ; 71) ; la deuxième région (35 ; 45 ; 63b ; 73b) couvrant une portion du deuxième fil (32 ; 62 ; 72) ; et la troisième région (34 ; 46 ; 63c ; 73c) étant située entre la première région (33 ; 44 ; 63a ; 73a) et la deuxième région (35 ; 45 ; 63b ; 73b) ;
la préparation (203) d'une couche d'oxyde (47) sur une surface du deuxième fil (32 ; 42 ; 62 ; 72) qui n'est pas couverte par la réserve photographique ;
l'évaporation (204 ; 505) d'une première couche supraconductrice (48) en oblique dans la direction allant de la première région (33 ; 44 ; 63a ; 73a) à la deuxième région (35 ; 45 ; 63b ; 73b) pour que soit obtenue la jonction Josephson ; et la première couche supraconductrice (48) couvrant une région sur le deuxième fil (32 ; 42 ; 62 ; 72) qui n'est pas couverte par la réserve photographique et une portion du substrat entre le deuxième fil (32 ; 42 ; 62 ; 72) et le premier fil (31 ; 41 ; 61 ; 71) ; et
l'évaporation (205 ; 507) d'une deuxième couche supraconductrice (49) en oblique dans la direction allant de la deuxième région (35 ; 45 ; 63b ; 73b) à la première région (33 ; 44 ; 63a ; 73a) ; et la deuxième couche supraconductrice (49) couvrant une région sur le premier fil (31 ; 41 ; 61 ; 71) qui n'est pas couverte par la réserve photographique, la portion du substrat entre le deuxième fil (32 ; 42 ; 62 ; 72) et le premier fil (31 ; 41 ; 61 ; 71), et une portion de la première couche supraconductrice (48).

2. Procédé selon la revendication 1, dans lequel la structure de contre-dépouille comprend en outre une quatrième région (73d) ; la quatrième région (73d) est une région d'ouverture de la structure de contre-dépouille ; et la deuxième région (35 ; 45 ; 63b ; 73b) est située entre la troisième région (34 ; 46 ; 63c ; 73c) et la quatrième région (73d).

3. Procédé selon la revendication 2, dans lequel la longueur de la deuxième région (35 ; 45 ; 63b ; 73b) est supérieure à celle de la première région (33 ; 44 ; 63a ; 73a), et la portion du deuxième fil (32 ; 42 ; 62 ; 72) couverte par la deuxième région (35 ; 45 ; 63b ; 73b) est située sur un côté de la deuxième région (35 ; 45 ; 63b ; 73b) proche de la troisième région (34 ; 46 ; 63c ; 73c).

4. Procédé selon l'une quelconque des revendications 1 à 3, dans lequel la préparation (203) d'une couche d'oxyde (47) sur une surface du deuxième fil (32 ; 42 ; 62 ; 72) qui n'est pas couverte par la réserve photographique comprend :
le placement (504) du substrat dans une chambre d'oxydation dans un environnement d'oxygène pur pour une oxydation ; et
lequel procédé comprend en outre :
avant l'évaporation (507) d'une deuxième couche supraconductrice (49) en oblique dans la direction allant de la deuxième région (35 ; 45 ; 63b ; 73b) à la première région (33 ; 44 ; 63a ; 73a) pour que soit obtenue la jonction Josephson, comprenant en outre :
la mise en œuvre (506) d'une gravure ionique en oblique dans la direction allant de la deuxième région (35 ; 45 ; 63b ; 73b) à la première région (33 ; 44 ; 63a ; 73a) pour éliminer une couche d'oxyde (47) sur une surface du premier fil (31 ; 41 ; 61 ; 71) qui n'est pas couverte par la réserve photographique.

5. Procédé selon la revendication 4, dans lequel la mise en œuvre d'une gravure ionique en oblique dans la direction allant de la deuxième région (35 ; 45 ; 63b ; 73b) à la première région (33 ; 44 ; 63a ; 73a) a une durée de 2 minutes à une puissance de gravure de 200 watts ; ou la pression dans la chambre d'oxydation est de 4 Torr, et la durée de l'oxydation du substrat dans la chambre d'oxydation est de 1 000 à 2 000 secondes.

6. Procédé selon l'une quelconque des revendications 1 à 3, dans lequel, avant la préparation (203) d'une couche d'oxyde (47) sur une surface du deuxième fil (32 ; 42 ; 62 ; 72) qui n'est pas couverte par la réserve photographique, le procédé comprend en outre :
la mise en œuvre (503) d'une gravure ionique sur des surfaces du premier fil (31 ; 41 ; 61 ; 71) et du deuxième fil (32 ; 42 ; 62 ; 72) qui ne sont pas couvertes par la réserve photographique.

7. Procédé selon la revendication 6, dans lequel la mise en œuvre de la gravure ionique sur des surfaces du premier fil (31 ; 41 ; 61 ; 71) et du deuxième fil (32 ; 42 ; 62 ; 72) qui ne sont pas couvertes par la réserve photographique comprend :
la rotation du substrat cependant que l'angle d'inclinaison de la gravure ionique est maintenu constant.

8. Procédé selon l'une quelconque des revendications 1 à 3, dans lequel la première couche supraconductrice (48) a une vitesse de croissance de revêtement de 1 nm par seconde, et l'épaisseur de la première couche supraconductrice (48) est de 100 nm ; et une ligne d'extension du premier fil (31 ; 41 ; 61 ; 71) croise le deuxième fil (32 ; 42 ; 62 ; 72).

9. Procédé selon la revendication 8, dans lequel, quand la ligne d'extension du premier fil (31 ; 41 ; 61 ; 71) croise le deuxième fil (32 ; 42 ; 62 ; 72), le premier fil (31 ; 41 ; 61 ; 71) est perpendiculaire au deuxième fil (32 ; 42 ; 62 ; 72), et le premier fil (31 ; 41 ; 61 ; 71) est parallèle à la structure de contre-dépouille.

10. Procédé selon l'une quelconque des revendications 1 à 3, dans lequel la préparation d'une structure de circuit sur un substrat par nano-impression comprend :
la préparation d'une couche de film supraconducteur sur le substrat ;
la déposition par revêtement centrifuge d'adhésif de nano-impression sur la couche de film supraconducteur ;
l'impression d'un motif de structure de la structure de circuit sur l'adhésif de nano-impression par l'intermédiaire d'une plaque de masque de nano-impression ;
la gravure sur la couche de film supraconducteur basée sur le motif de structure ; et
le lavage de l'adhésif de nano-impression sur le substrat pour que soit obtenue la structure de circuit située sur le substrat,
dans lequel l'épaisseur de la couche de film supraconducteur est de 100 nm.

11. Procédé selon la revendication 10, dans lequel la gravure sur la couche de film supraconducteur basée sur le motif de structure comprend :
la gravure sur la couche de film supraconducteur basée sur le motif de structure par gravure à sec ; ou
dans lequel, avant la gravure sur la couche de film supraconducteur basée sur le motif de structure, le procédé comprend en outre :
l'élimination de l'adhésif de nano-impression restant dans une rainure d'impression de l'adhésif de nano-impression.

12. Système pour préparer une jonction Josephson, le système comprenant : un sous-système de nano-impression (1401), un sous-système de photolithographie (1402), un sous-système d'oxydation (1403), et un sous-système d'évaporation (1404) ; dans lequel
le sous-système de nano-impression (1401) est configuré pour préparer une structure de circuit sur un substrat par nano-impression ; la structure de circuit comprenant un premier fil (31 ; 41 ; 61 ; 71), un deuxième fil (32 ; 42 ; 62 ; 72) et un circuit périphérique connecté au premier fil (31 ; 41 ; 61 ; 71) et au deuxième fil (32 ; 42 ; 62 ; 72) ; et le premier fil (31 ; 41 ; 61 ; 71), le deuxième fil (32 ; 42 ; 62 ; 72) et le circuit périphérique ayant une structure solidaire ;
le sous-système de photolithographie (1402) est configuré pour préparer une structure de contre-dépouille à base de réserve photographique sur le substrat ; la structure de contre-dépouille étant une structure en forme de bande, et la structure de contre-dépouille comprenant une première région (33 ; 44 ; 63a ; 73a), une deuxième région (35 ; 45 ; 63b ; 73b) et une troisième région (34 ; 46 ; 63c ; 73c) connectée entre la première région (33 ; 44 ; 63a ; 73a) et la deuxième région (35 ; 45 ; 63b ; 73b) ; la première région (33 ; 44 ; 63a ; 73a) et la deuxième région (35 ; 45 ; 63b ; 73b) ayant des couches de réserve photographique supérieures et des couches inférieures de creux-dehors ; la troisième région (34 ; 46 ; 63c ; 73c) étant une région d'ouverture de la structure de contre-dépouille ; la première région (33 ; 44 ; 63a ; 73a) couvrant une extrémité du premier fil (31 ; 41 ; 61 ; 71) ; la deuxième région (35 ; 45 ; 63b ; 73b) couvrant une portion du deuxième fil (32 ; 42 ; 62 ; 72) ; et la troisième région (34 ; 46 ; 63c ; 73c) étant située entre la première région (33 ; 44 ; 63a ; 73a) et la deuxième région (35 ; 45 ; 63b ; 73b) ;
le sous-système d'oxydation (1403) est configuré pour préparer une couche d'oxyde (47) sur une surface du deuxième fil (32 ; 42 ; 62 ; 72) qui n'est pas couverte par la réserve photographique ;
le sous-système d'évaporation (1401) est configuré pour évaporer une première couche supraconductrice (48) en oblique dans la direction allant de la première région (33 ; 44 ; 63a ; 73a) à la deuxième région pour que soit obtenue la jonction Josephson ; et la première couche supraconductrice (48) couvrant une région sur le deuxième fil (32 ; 42 ; 62 ; 72) qui n'est pas couverte par la réserve photographique et une portion du substrat entre le deuxième fil (32 ; 42 ; 62 ; 72) et le premier fil (31 ; 41 ; 61 ; 71) ; et
le sous-système d'évaporation (1404) est en outre configuré pour évaporer une deuxième couche supraconductrice (49) en oblique dans la direction allant de la deuxième région (35 ; 45 ; 63b ; 73b) à la première région (33 ; 44 ; 63a ; 73a) ; et la deuxième couche supraconductrice (49) couvrant une région sur le premier fil (31 ; 41 ; 61 ; 71) qui n'est pas couverte par la réserve photographique, la portion du substrat entre le deuxième fil (32 ; 42 ; 62 ; 72) et le premier fil (31 ; 41 ; 61 ; 71), et une portion de la première couche supraconductrice (48).

13. Système pour préparer une jonction Josephson selon la revendication 12, dans lequel la structure de contre-dépouille comprend en outre une quatrième région (73d) ; la quatrième région (73d) est une région d'ouverture de la structure de contre-dépouille ; et la deuxième région (35 ; 45 ; 63b ; 73b) est située entre la troisième région (34 ; 46 ; 63c ; 73c) et la quatrième région (73d).

14. Système pour préparer une jonction Josephson selon la revendication 13, dans lequel la longueur de la deuxième région (35 ; 45 ; 63b ; 73b) est supérieure à celle de la première région (33 ; 44 ; 63a ; 73a), et la portion du deuxième fil (32 ; 42 ; 62 ; 72) couverte par la deuxième région (35 ; 45 ; 63b ; 73b) est située sur un côté de la deuxième région (35 ; 45 ; 63b ; 73b) proche de la troisième région (34 ; 46 ; 63c ; 73c).

15. Système pour préparer une jonction Josephson selon l'une quelconque des revendications 12 à 14, dans lequel le sous-système d'oxydation (1403) est configuré pour placer le substrat dans une chambre d'oxydation dans un environnement d'oxygène pur pour une oxydation ;
lequel système pour préparer une jonction Josephson comprend en outre : un sous-système de gravure, configuré pour mettre en œuvre une gravure ionique en oblique dans la direction allant de la deuxième région (35 ; 45 ; 63b ; 73b) à la première région (33 ; 44 ; 63a ; 73a) pour éliminer une couche d'oxyde (47) sur une surface du premier fil (31 ; 41 ; 61 ; 71) qui n'est pas couverte par la réserve photographique.
